# EUROPEAN PATENT APPLICATION

(11) **EP 3 428 726 A1**
(43) Date of publication of application: **16.01.2019**
(21) Application number: 17181208.4
(22) Date of filing: 13.07.2017
(51) Int. Cl.: G03F 9/00, G01N 23/225, G01R 31/305

(54) **INSPECTION TOOL, LITHOGRAPHIC APPARATUS, LITHOGRAPHIC SYSTEM, INSPECTION METHOD AND DEVICE MANUFACTURING METHOD**

(71) Applicant: ASML Netherlands B.V., 5500 AH Veldhoven (NL)
(72) Inventor: QUINTANILHA, Richard, 5500 AH Veldhoven (NL); SMAKMAN, Erwin, Paul, 5500 AH Veldhoven (NL)
(74) Representative: Peters, John Antoine

(57) **Abstract**

An inspection tool for inspecting a semiconductor substrate is described, the inspection tool comprising:
- an substrate table configured to hold the substrate;
- an electron beam source configured to project an electron beam onto an area of interest of the substrate, the area of interest comprising a buried structure;
- a cathode-luminesce detector configured to detect cathodoluminescent light emitted from the buried structure;
- a control unit configured to:
- control the electron beam source to project to electron beam onto the area of interest;
- receive a signal representative of the detected cathodoluminescent light;
- determine, based on the signal, a characteristic of the buried structure.

## Description

### BACKGROUND

### Field of the Invention

The present invention relates to an inspection tool, a lithographic apparatus, a lithographic system, an inspection method and a method for manufacturing a device.

### Description of the Related Art

A lithographic apparatus is a machine that applies a desired pattern onto a substrate, usually onto a target portion of the substrate. A lithographic apparatus can be used, for example, in the manufacture of integrated circuits (ICs). In such a case, a patterning device, which is alternatively referred to as a mask or a reticle, may be used to generate a circuit pattern to be formed on an individual layer of the IC. This pattern can be transferred onto a target portion (e.g. including part of, one, or several dies) on a substrate (e.g. a silicon wafer). Transfer of the pattern is typically via imaging onto a layer of radiation-sensitive material (resist) provided on the substrate. In general, a single substrate will contain a network of adjacent target portions that are successively patterned. Conventional lithographic apparatus include so-called steppers, in which each target portion is irradiated by exposing an entire pattern onto the target portion at once, and so-called scanners, in which each target portion is irradiated by scanning the pattern through a radiation beam in a given direction (the "scanning"-direction) while synchronously scanning the substrate parallel or anti-parallel to this direction. It is also possible to transfer the pattern from the patterning device to the substrate by imprinting the pattern onto the substrate.

The radiation beam as typically applied in lithographic apparatuses may e.g. be a DUV radiation beam (e.g. having a wavelength of 248 nm or 193 nm) or an EUV radiation beam (.e.g. having a wavelength of 11 nm or 13.5 nm).

The manufacturing of an integrated circuit may typically require the stacking of a plurality of layers, whereby the layers need to be accurately aligned. Without such an alignment, a required connection between layers may be flawed, resulting in a malfunctioning of the integrated circuit.

Typically, the bottom layer or layers of the integrated circuit will contain the smallest structures, such as transistors or components thereof. The structures of subsequent layers are typically larger and enable connections of the structures in the bottom layers to the outside world. In view of this, an alignment of two layers will be the most challenging in the bottom portion of the integrated circuit.

In order to realize such an alignment, use it typically made of a plurality of alignment marks that are provided on the substrate, the position of the alignment marks being indicative of the position of the patterned structures. Due to various process steps that are performed between the exposure processes of two consecutive layers, it may be cumbersome to determine an actual position of the alignment marks. In particular, processing steps such as CMP may result in a deformation of the alignment marks. As a result, the determination of the actual position of the alignment marks may be flawed, resulting in an erroneous or inaccurate assessment of the position of the patterned structures.

In case an erroneous assessment is made of the position of the alignment marks, an overlay error may be made during the exposure process whereby a next patterned layer is generated. Such an error may affect the functionality of the semiconductor device that is manufactured.

It would be beneficial to assess whether or not the desired functionality of a semiconductor device will be met, in an early stage of the manufacturing process.

### SUMMARY

It is desirable to enable an early assessment whether or not a desired functionality of a semiconductor device will be.

According to an embodiment of the present invention, there is provided an inspection tool for inspecting a semiconductor substrate, the inspection tool comprising
- an substrate table configured to hold the substrate;
- an electron beam source configured to project an electron beam onto an area of interest of the substrate, the area of interest comprising a buried structure;
- a cathode-luminesce detector configured to detect cathodoluminescent light emitted from the buried structure;
- a control unit configured to:
   - receive a signal representative of the detected cathodoluminescent light;
   - determine, based on the signal, a characteristic of the buried structure.

According to an embodiment of the invention, there is provided a lithographic apparatus comprising:
- an illumination system configured to condition a radiation beam;
- a support constructed to support a patterning device, the patterning device being capable of imparting the radiation beam with a pattern in its cross-section to form a patterned radiation beam;
- a projection system configured to project the patterned radiation beam onto a target portion of a substrate;
wherein the apparatus further comprises an inspection tool according to the present invention and a stage apparatus configured to position the substrate table so as to impart the substrate with the patterned radiation beam.

According to an embodiment of the invention, there is provided a lithographic system comprising:
- a lithographic apparatus comprising:
   - an illumination system configured to condition a radiation beam;
   - a support constructed to support a patterning device, the patterning device being capable of imparting the radiation beam with a pattern in its cross-section to form a patterned radiation beam;
   - a projection system configured to project the patterned radiation beam onto a target portion of a substrate;
   - a stage apparatus configured to position the substrate table so as to impart the substrate with the patterned radiation beam;
- an inspection tool according to the present invention.

According to an embodiment of the invention, there is provided an inspection method, the method comprising the steps of:
- providing a substrate with an area of interest, the area of interest comprising a buried structure;
- scanning the area of interest using an electron beam;
- capturing CL-light emitted from the area of interest;
- determining a characteristic of the buried structure.

According to an embodiment of the invention, there is provided a device manufacturing method comprising projecting a patterned beam of radiation onto a substrate, wherein the step of projecting the patterned beam of radiation onto the substrate is preceded by the inspection method according to the present invention.

### BRIEF DESCRIPTION OF THE DRAWINGS

Embodiments of the invention will now be described, by way of example only, with reference to the accompanying schematic drawings in which corresponding reference symbols indicate corresponding parts, and in which:
Figure 1 depicts a lithographic apparatus according to an embodiment of the invention;
Figure 2 depicts an inspection tool according to an embodiment of the invention;
Figure 3 depicts a frequency spectrum of CL-light as can be determined by an inspection tool according to the present invention;
Figure 4 schematically depicts a cross-sectional view of a structure that can be examined using an inspection tool according to the present invention;
Figure 5 schematically depicts a cross-sectional view of another structure that can be examined using an inspection tool according to the present invention;
Figure 6 schematically depicts a variation of the frequency spectrum of the received CL-light along the area of interest.
Figures 7-9 schematically show possible images of the area of interest, derived from the captured CL-light.
Figure 10 schematically depicts a cross-sectional view of an overlay mark as can be examined using an inspection tool according to the present invention.

### DETAILED DESCRIPTION

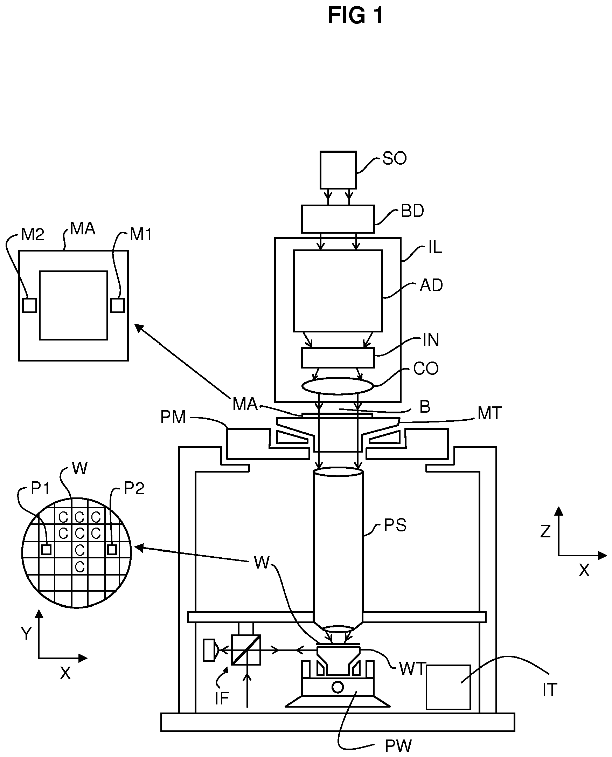

Figure 1 schematically depicts a lithographic apparatus according to one embodiment of the invention. The apparatus includes an illumination system (illuminator) IL configured to condition a radiation beam B (e.g. UV radiation or any other suitable radiation), a mask support structure (e.g. a mask table) MT constructed to support a patterning device (e.g. a mask) MA and connected to a first positioning device PM configured to accurately position the patterning device in accordance with certain parameters. The apparatus also includes a substrate table (e.g. a wafer table) WT or "substrate support" constructed to hold a substrate (e.g. a resist-coated wafer) W and connected to a second positioning device PW configured to accurately position the substrate in accordance with certain parameters. The apparatus further includes a projection system (e.g. a refractive projection lens system) PS configured to project a pattern imparted to the radiation beam B by patterning device MA onto a target portion C (e.g. including one or more dies) of the substrate W.

The illumination system may include various types of optical components, such as refractive, reflective, magnetic, electromagnetic, electrostatic or other types of optical components, or any combination thereof, for directing, shaping, or controlling radiation.

The mask support structure supports, i.e. bears the weight of, the patterning device. It holds the patterning device in a manner that depends on the orientation of the patterning device, the design of the lithographic apparatus, and other conditions, such as for example whether or not the patterning device is held in a vacuum environment. The mask support structure can use mechanical, vacuum, electrostatic or other clamping techniques to hold the patterning device. The mask support structure may be a frame or a table, for example, which may be fixed or movable as required. The mask support structure may ensure that the patterning device is at a desired position, for example with respect to the projection system. Any use of the terms "reticle" or "mask" herein may be considered synonymous with the more general term "patterning device."

The term "patterning device" used herein should be broadly interpreted as referring to any device that can be used to impart a radiation beam with a pattern in its cross-section so as to create a pattern in a target portion of the substrate. It should be noted that the pattern imparted to the radiation beam may not exactly correspond to the desired pattern in the target portion of the substrate, for example if the pattern includes phase-shifting features or so called assist features. Generally, the pattern imparted to the radiation beam will correspond to a particular functional layer in a device being created in the target portion, such as an integrated circuit.

The patterning device may be transmissive or reflective. Examples of patterning devices include masks, programmable mirror arrays, and programmable LCD panels. Masks are well known in lithography, and include mask types such as binary, alternating phase-shift, and attenuated phase-shift, as well as various hybrid mask types. An example of a programmable mirror array employs a matrix arrangement of small mirrors, each of which can be individually tilted so as to reflect an incoming radiation beam in different directions. The tilted mirrors impart a pattern in a radiation beam which is reflected by the mirror matrix.

The term "projection system" used herein should be broadly interpreted as encompassing any type of projection system, including refractive, reflective, catadioptric, magnetic, electromagnetic and electrostatic optical systems, or any combination thereof, as appropriate for the exposure radiation being used, or for other factors such as the use of an immersion liquid or the use of a vacuum. Any use of the term "projection lens" herein may be considered as synonymous with the more general term "projection system".

As here depicted, the apparatus is of a transmissive type (e.g. employing a transmissive mask). Alternatively, the apparatus may be of a reflective type (e.g. employing a programmable mirror array of a type as referred to above, or employing a reflective mask)

The lithographic apparatus may be of a type having two (dual stage) or more substrate tables or "substrate supports" (and/or two or more mask tables or "mask supports"). In such "multiple stage" machines the additional tables or supports may be used in parallel, or preparatory steps may be carried out on one or more tables or supports while one or more other tables or supports are being used for exposure.

The lithographic apparatus may also be of a type wherein at least a portion of the substrate may be covered by a liquid having a relatively high refractive index, e.g. water, so as to fill a space between the projection system and the substrate. An immersion liquid may also be applied to other spaces in the lithographic apparatus, for example, between the mask and the projection system. Immersion techniques can be used to increase the numerical aperture of projection systems. The term "immersion" as used herein does not mean that a structure, such as a substrate, must be submerged in liquid, but rather only means that a liquid is located between the projection system and the substrate during exposure.

Referring to figure 1, the illuminator IL receives a radiation beam from a radiation source SO. The source and the lithographic apparatus may be separate entities, for example when the source is an excimer laser. In such cases, the source is not considered to form part of the lithographic apparatus and the radiation beam is passed from the source SO to the illuminator IL with the aid of a beam delivery system BD including, for example, suitable directing mirrors and/or a beam expander. In other cases the source may be an integral part of the lithographic apparatus, for example when the source is a mercury lamp. The source SO and the illuminator IL, together with the beam delivery system BD if required, may be referred to as a radiation system.

The illuminator IL may include an adjuster AD configured to adjust the angular intensity distribution of the radiation beam. Generally, at least the outer and/or inner radial extent (commonly referred to as σ-outer and σ-inner, respectively) of the intensity distribution in a pupil plane of the illuminator can be adjusted. In addition, the illuminator IL may include various other components, such as an integrator IN and a condenser CO. The illuminator may be used to condition the radiation beam, to have a desired uniformity and intensity distribution in its cross-section.

The radiation beam B is incident on the patterning device (e.g., mask MA), which is held on the mask support structure (e.g., mask table MT), and is patterned by the patterning device. Having traversed the mask MA, the radiation beam B passes through the projection system PS, which focuses the beam onto a target portion C of the substrate W. With the aid of the second positioning device PW and position sensor IF (e.g. an interferometric device, linear encoder or capacitive sensor), the substrate table WT can be moved accurately, e.g. so as to position different target portions C in the path of the radiation beam B. Similarly, the first positioning device PM and another position sensor (which is not explicitly depicted in Figure 1) can be used to accurately position the mask MA with respect to the path of the radiation beam B, e.g. after mechanical retrieval from a mask library, or during a scan. In general, movement of the mask table MT may be realized with the aid of a long-stroke module (coarse positioning) and a short-stroke module (fine positioning), which form part of the first positioning device PM. Similarly, movement of the substrate table WT or "substrate support" may be realized using a long-stroke module and a short-stroke module, which form part of the second positioning device PW. In the case of a stepper (as opposed to a scanner) the mask table MT may be connected to a short-stroke actuator only, or may be fixed. Mask MA and substrate W may be aligned using mask alignment marks M1, M2 and substrate alignment marks PI, P2. Although the substrate alignment marks as illustrated occupy dedicated target portions, they may be located in spaces between target portions (these are known as scribe-lane alignment marks). Similarly, in situations in which more than one die is provided on the mask MA, the mask alignment marks may be located between the dies.

The depicted apparatus could be used in at least one of the following modes:
1. In step mode, the mask table MT or "mask support" and the substrate table WT or "substrate support" are kept essentially stationary, while an entire pattern imparted to the radiation beam is projected onto a target portion C at one time (i.e. a single static exposure). The substrate table WT or "substrate support" is then shifted in the X and/or Y direction so that a different target portion C can be exposed. In step mode, the maximum size of the exposure field limits the size of the target portion C imaged in a single static exposure.
2. In scan mode, the mask table MT or "mask support" and the substrate table WT or "substrate support" are scanned synchronously while a pattern imparted to the radiation beam is projected onto a target portion C (i.e. a single dynamic exposure). The velocity and direction of the substrate table WT or "substrate support" relative to the mask table MT or "mask support" may be determined by the (de-)magnification and image reversal characteristics of the projection system PS. In scan mode, the maximum size of the exposure field limits the width (in the non-scanning direction) of the target portion in a single dynamic exposure, whereas the length of the scanning motion determines the height (in the scanning direction) of the target portion.
3. In another mode, the mask table MT or "mask support" is kept essentially stationary holding a programmable patterning device, and the substrate table WT or "substrate support" is moved or scanned while a pattern imparted to the radiation beam is projected onto a target portion C. In this mode, generally a pulsed radiation source is employed and the programmable patterning device is updated as required after each movement of the substrate table WT or "substrate support" or in between successive radiation pulses during a scan. This mode of operation can be readily applied to maskless lithography that utilizes programmable patterning device, such as a programmable mirror array of a type as referred to above.

Combinations and/or variations on the above described modes of use or entirely different modes of use may also be employed.

In the embodiment as shown, the lithographic apparatus further comprises an inspection tool IT according to the invention. Such an inspection tool IT may e.g. enable to determine a characteristic of a structure, in particular a buried structure that is present on or in an area of interest of a substrate W that is processed by the lithographic apparatus. In an embodiment, as will be discussed in more detail below, the inspection tool may comprise an electron beam source for inspecting the substrate.

In an embodiment, the second positioning device PW may be configured to position the substrate W in the operating range of the inspection tool IT. In such an embodiment, the inspection tool IT may e.g. be configured to determine a characteristic of the mentioned structure, e.g. an electric characteristic, a material characteristic and/or a geometric characteristic. In an embodiment, this information may subsequently be provided to a control unit of the lithographic apparatus and used during the exposure process, e.g. by controlling one or more of the illumination system, the projection system or one of the positioning devices, based on the information.

In the embodiment as shown, the lithographic apparatus may be configured to apply DUV radiation for the radiation beam. In such case, the patterning device MA may be a transmissive patterning device and the projection system PS may comprise one or more lenses.

Alternatively, the lithographic apparatus according to the present invention may be configured to apply EUV radiation for the radiation beam. In such case, the patterning device MA may be a reflective patterning device and the projection system PS may comprise one or more mirrors. In such embodiment, the apparatus may comprise one or more vacuum chambers for housing the illumination system IL and/or the projection system PS.

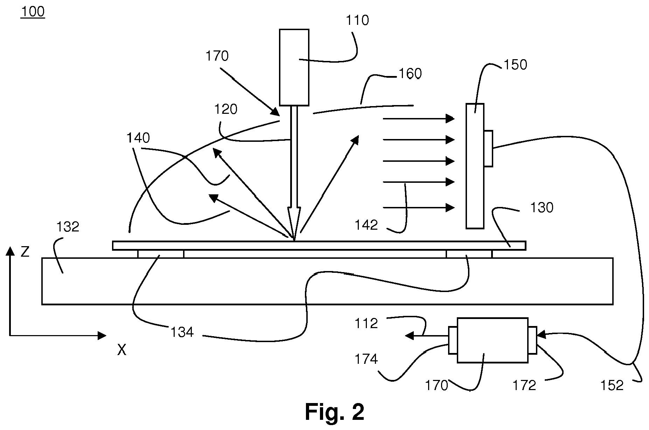

According to an aspect of the invention, there is provided an inspection tool configured to inspect an object such as a substrate. Figure 2 schematically shows an embodiment of such an inspection tool 100. In accordance with the present invention, the inspection tool 100 comprises an electron beam source 110, further on also referred to as an e-beam source 110. Such an e-beam source 110 is known in general, and may be applied in the present invention to project an electron beam 120 onto an area of an object 130, e.g. a substrate. In the embodiment as shown, the object 130 is mounted to an object table 132 by means of a clamping mechanism 134, e.g. a vacuum clamp or an electrostatic clamp. The area of the object onto which the e-beam is projected may also be referred to as sample. Such an e-beam source 110 may e.g. be used to generate an electron beam 120 having an energy ranging from 0.2 keV to 100 keV. An e-beam source 110 may typically have one or more lenses for focusing the electron beam 120 onto a spot of about 0.4 to 5 nm in diameter. In an embodiment, the e-beam source 110 may further comprise one or more scanning coils or deflector plates which may deflect the electron beam 120. By doing so, the electron beam 120 may e.g. be deflected along an X-axis and an Y-axis (perpendicular to the X-axis and the Z-axis), the XY-plane being parallel to a surface of the object, such that an area of the object can be scanned.
In an embodiment of the present invention, the electron beam source is configured to project a plurality of electron beams onto a respective plurality of sub-areas of the area of interest. By doing so, the area of interest that can be examined or inspected per unit of time may be enlarged. Further, in an embodiment of the present invention, the electron beam source may be configured to generate electron beams having a different energy level. As will be explained in more detail below, depending on the applied energy level for the e-beam or beams, different portions or a structure, e.g. a buried structure, may be examined. When such an e-beam 120 impinges on the surface, interactions on the surface and interactions with the material below the surface will occur, resulting in the exposed surface emitting both radiation and electrons. Typically, when an electron beam 120 interacts with a sample, the electrons constituting the beam will loose energy through scattering and absorption, within a teardrop-shaped volume, known as the interaction volume. The energy exchange between the electron beam and the sample will typically result in a combination of:
- the reflection of high energy electrons by elastic scattering,
- an emission of secondary electrons by inelastic scattering,
- an emission of electrons that are reflected or back-scattered out of the interaction volume by elastic scattering interactions with the sample,
- X-ray emission, and
- an emission of electromagnetic radiation, e.g. in a range from deep UV to IR.
The latter emission of electromagnetic radiation is generally referred to as cathodoluminescent light or CL-light. In Figure 2, the arrows 140 are indicative for the emitted cathodoluminescent light.
In an embodiment of the present invention, the inspection tool 100 further comprises a detector 150 for detection such cathodoluminescent light 140 emitted by a sample. In the embodiment as shown, the inspection tool 100 comprises a reflector 160, e.g. an elliptical or parabolic reflector to redirect the CL-light 140 towards the detector 150, as indicated by the arrows 142. In the embodiment as shown, the reflector 160 is provided with an aperture 170, through which the e-beam 120 can be directed towards the object 130.

The detector 150 as applied in the inspection tool 100 according to the present invention may e.g. be formed as a CCD array, e.g. a two-dimensional CCD array, a hyperspectral sensor or a spectrograph. In an embodiment of the present invention, the inspection tool further comprises a control unit 170 or processing unit, e.g. comprising a microprocessor, computer or the like, for processing the CL-light 140, 142 as detected by the detector 150. In an embodiment, the control unit 170 comprises an input terminal 172 for receiving a signal 152 from the detector 150, the signal 152 representing the detected CL-light 142 emitted by the object 130.
In an embodiment, the control unit may further have an output terminal 174 for outputting a control signal 112 for controlling the e-beam source 110. In an embodiment, the control unit 170 may control the e-beam source 110 to project an e-beam 120 onto an area of interest of the object to be inspected, e.g. a semiconductor substrate.
In an embodiment, the control unit 170 may be configured to control the e-beam source 110 to scan the area of interest.

During such scanning of an area of interest of an object, the detector may receive CL-light 142 from different portions of the area of interest. As an example, the applied e-beam may e.g. have a cross-section of 1 - 4 nm in diameter, while the area of interest is 100 nm x 100 nm. As such, when the area of interest has been scanned, a response to the e-beam across the area of interest may have been captured by the CL-light detector 150.

In an embodiment, the control unit 170 as applied in the inspection tool 100 according to the present invention may be configured to determine a frequency spectrum of the CL-light as received by the detector 150.

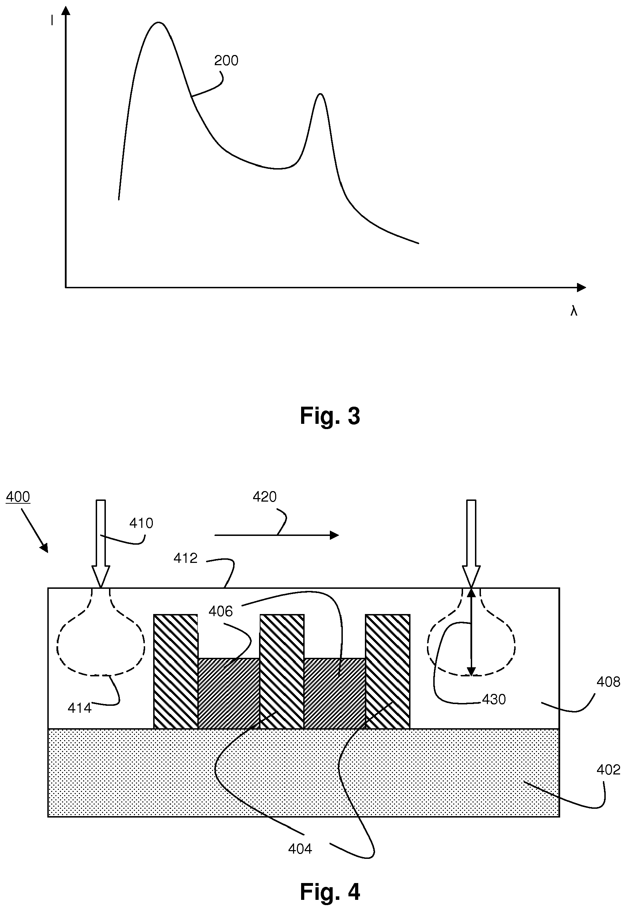

Figure 3 schematically shows a frequency spectrum 200, indicating the intensity I of the received CL-light as a function of the wavelength λ.
In general, the frequency spectrum of the received CL-light may depend on various parameters. As will be understood, the frequency spectrum may depend on the material that is probed by the e-beam. In case of a semiconductor substrate, the area of interest that is examined may comprise structures that form part of integrated circuits of semiconductor devices. These structures or devices will typically comprise different materials, e.g. different semiconductor materials having different dopant materials or different dopant concentrations. Each of these materials may result in the generation of a particular CL-light having a particular frequency spectrum. Since the CL-light is generated in volume underneath the surface of the object, referred to as the interaction volume, the CL-light as received may originate from a combination of different materials, in case the interaction volume would encompass different materials or structures.
As will be explained in more detail below, by changing the energy of the e-beam, it is possible to change the volume that is probed and in particular the depth of the probed volume, i.e. the interaction volume, which enables access to buried materials and structures and enables the creating of a 3D mapping.

Figure 4 highly schematically shows a cross-sectional view of a semiconductor structure 400 comprising multiple layers and different materials. The structure 400 as schematically shown in Figure 4 comprises a bottom layer 402 of a first material, three vertically extending structures 404 of a second material on top of said bottom layer 402, a gap between adjacent structures 402 being partially filled with structures 406 of a third material and the structures 404 and 406 being covered by a top layer 408 of a fourth material. Figure 4 further schematically shows an e-beam 410 impinging on the top surface 412 of the structure 400. Indicated by the dotted line 414 is the interaction volume of the e-beam 410, i.e. the volume where CL-light may be generated as a result of the applied e-beam. It can be noted that, while the e-beam may have a diameter of only a few nm, the interaction volume will typically have a larger diameter, e.g. 10-20 nm. Figure 4 further illustrates the scanning of the e-beam (indicated by arrow 420) towards the right, thereby moving the interaction volume 414 across the structures 404 and 406. During said scanning, the interaction volume 414 will encompass the various materials of the structures. As such, during such scanning movement, variations in the frequency spectrum of the CL-light will occur; based on these variations, one may thus deduce that different materials or structures are present underneath the surface 412. In this respect it can be noted that the CL-light as generated is typically strongly material dependent.

With respect to the interaction volume 414 as schematically indicated in Figure 4, it is further worth mentioning that the height or depth 430 of the interaction volume 414 will depend, among others, on the energy level of the applied e-beam 410. As will be understood by the skilled person, the e-beam 410 will not be able to penetrate deep into the structure 400 in case the energy level of the electrons is comparatively low. In such case, the interactions may be limited to interactions with the material at or near the surface 412, i.e. material 408.

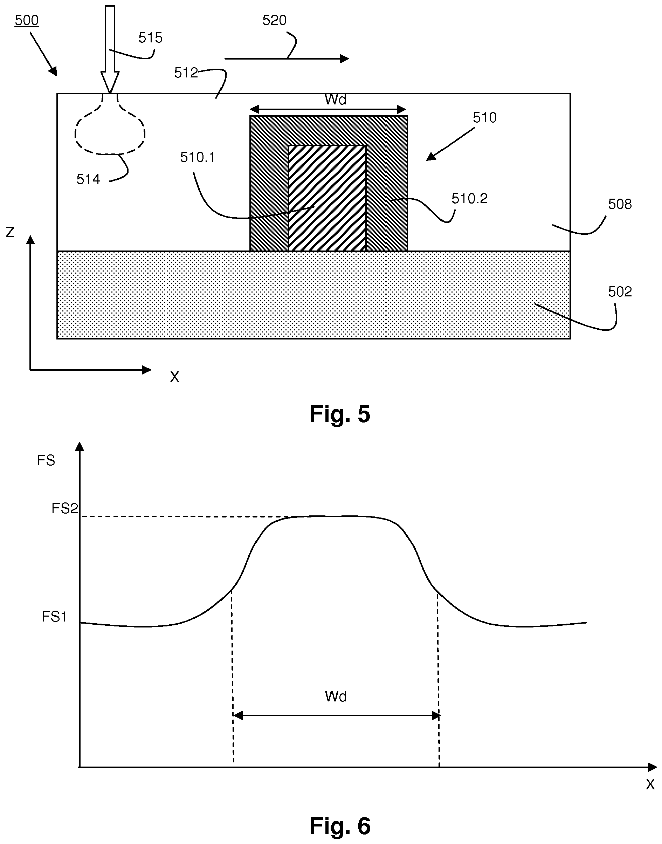

When the surface 412 is scanned with an e-beam 410 having a comparatively high energy level, the interaction volume will extend deeper into the structure 400, resulting in the detection of the different materials and structures, based on the observed variations in the CL-light spectra observed during the scan.
As such, by scanning the area of interest with e-beams of different intensity or energy levels, insight can be gained on the location of various structures and/or on the thickness of different layers of materials.
Further, it can be mentioned that positions at which variations of the frequency spectrum are detected can be used to acquire geometric characteristics of the structure that is examined. This is schematically illustrated in Figure 5.

Figure 5 highly schematically depicts a cross-sectional view on an area of interest 500 comprising a buried structure 510 provided on a layer 502, e.g. made of a first material. The buried structure 510 comprising a vertically extending structure 510.1 made of another, second material and an enclosing structure 510.2, made of a third material, surrounding the side surfaces and the top surface of the structure 510.1. The structure 510 is further embedded, or enclosed or covered by a layer 508 of yet another material. In case the surface 512 of the area of interest is scanned with an electron beam 515 having an interaction volume 514 as indicated, in a direction as indicated by arrow 520, some variations in the frequency spectrum of the emitted CL-light may be observed. In particular, in case the electron beam 515 is moved along the X-axis starting from the position as shown, one can expect the frequency spectrum to remain substantially constant at a first frequency spectrum, until the e-beam 515 reaches a position (along the X-axis) where the interaction volume will start to interact with the enclosing structure 510.2. When the electron beam 515 is moved further to the right, the frequency spectrum will gradually change, will remain constant for a certain displacement along the X-axis, at a second frequency spectrum and will then gradually change again towards the first frequency spectrum.

This transition is schematically shown in Figure 6. Figure 6 schematically shows the frequency spectrum FS observed when an electron beam 515 is scanned across the area of interest, i.e. in the X-direction as indicated in Figure 5. As can be seen, starting from a spectrum FS1, the spectrum will at some point start to change, towards a second spectrum FS2, which may remain constant and will then gradually change again towards the first spectrum FS 1. Since the positions of the transitions can be associated with the interaction volume of the e-beam gradually changing from interacting with one material, e.g. the material of the layer 508, to interacting with another material, e.g. the material of the enclosing structure 510.2. Based upon the positions, along the X-axis, where the transitions occur, one may be able to determine or estimate a width Wd of the material having the second frequency spectrum FS2.

In a similar manner, one can expect that, when a more intense e-beam is applied, i.e. an e-beam having an interaction volume that penetrates deeper into the area of interest, a transition to a third frequency spectrum may occur, representative of the material of the structure 510.1 which would enable to make an assessment of the width of the structure 510.1 in the X-direction. As such, using the inspection tool according to the present invention, an assessment can be made of both material or chemical characteristics as well as geometrical characteristics of a buried structure.

An alternative to determining the geometric properties of the buried structure by means of assessing variations in the frequency spectrum as observed, on may also consider using the emitted CL-light to generate an image of the area of interest and assess any geometric properties based on the image. Such an image may contain areas of different intensity or color, whereby the locations of contours or boundaries may be used to assess geometric properties of the structure. It may be worth mentioning that such boundaries between two areas may be somewhat blurred. This may be understood as cause by the fact that the probing of the material is in fact done in the interaction volume, thus resulting in a gradual transition between materials or structures.

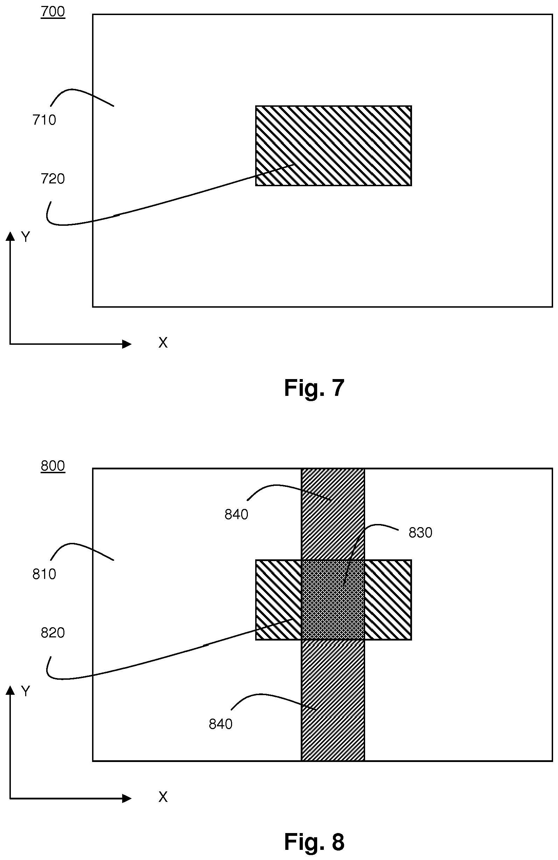

Figure 7 schematically shows a possible image 700 of the buried structure of Figure 5, whereby the image reveals two different regions, one region 710 where the interaction volume of the e-beam only interacts with material of the layer 508 of Figure 5 and one region 720 where the interaction region also interacts with the enclosing structure 510.2. Figure 8 schematically shows an image 800 of the same region of interest but with an interaction volume that also penetrates the structure 510.1 In the image 800, 4 different regions can be identified: one region 810 where the interaction volume of the e-beam only interacts with material of the layer 508 of Figure 5, one region 820 where the interaction region interacts with the layer 508 and the enclosing structure 510.2, one region 830 where the interaction region interacts with the layer 508, the structure 510.1 and the enclosing structure 510.2, and one region 840 where the interaction region interacts with the layer 508 and the structure 510.1. upon review of the image, one can e.g. notice that the structure 510.1 extend longer in the Y-direction than the enclosing structure 510.2. Based on the image and e.g. combined with design data that is known a priori, one can e.g. recognize that the structure 510.1 may e.g. be a fin of a fin-FET and that the enclosing structure 510.2 may e.g. be a gate electrode enclosing the fin of the fin-FET.

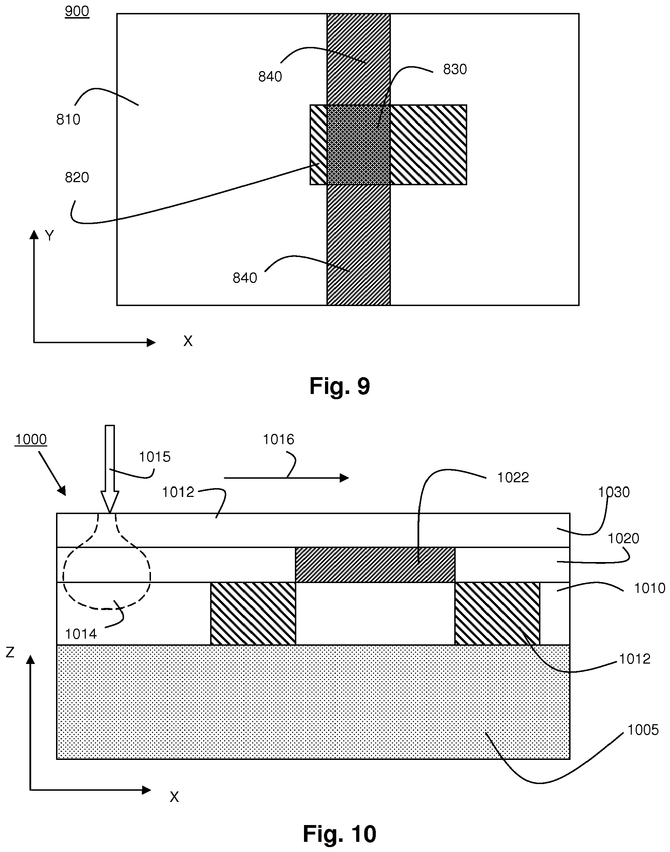

Apart from assessing material or chemical characteristics of the different regions or structures that interact with the interaction volume of the e-beam as applied, any irregularities in the structure may be identified as well. In order to function properly, there are different requirements for the different materials or structures forming a semiconductor device. These requirement include the materials or structures having the right material characteristics and right sizes, but also, the different structures need to be in the right position relative to each other. Using the inspection tool according to the present invention, one can equally assess whether or not the different buried structures or structure component are arranged as intended, relative to each other. With reference to the structure shown in Figure 5, it may e.g. be required that the gate electrode, i.e. the enclosing structure 510.2 is positioned symmetrically over the fin structure, i.e. the structure 510.1. Based on the images of the captured CL-light, e.g. image 800 of Figure 8, one can assess whether or not such a symmetry is present. In case the image of the captured CL-light over the area of interest would look like the image 900 in Figure 9, one could e.g. conclude that the gate electrode, i.e. the structure 510.2 shown in Figure 5 is not arranged symmetrically about the fin-FET, i.e. the structure 510.1 shown in Figure 5. Such an asymmetry may result in a less than optimal operation of the fin-FET.

As such, in an embodiment of the present invention, the information obtained, either material characteristics or properties or geometrical characteristics, or both, may be used to assess a functionality of the semiconductor device that is manufactured. Note that, in an embodiment, the information derived from the operation of the inspection tool may also be combined with information of other sources to arrive at an assessment of the functionality of the semiconductor device.

Another example of an assessment of the proper relative positions of structures, as can be determined using the present invention, is an assessment of overlay. Overlay refers in general to the manner in which two consecutive layers formed on a semiconductor substrate are aligned. To assess this alignment, a first structure may be formed in the bottom layer, e.g. during the exposure of the bottom layer, and a second structure may be formed in the top layer, e.g. during the exposure of the top layer. The combination of the first and second structure may e.g. be referred to as an overlay mark. Figure 10 schematically shows a cross-sectional view of such an overlay mark 1000, showing a bottom patterned layer 1010 comprising a first structure 1012 and a top patterned layer 1020 comprising a second structure 1022, the bottom layer 1010 being arranged on a layer 1005 of the substrate, and the top layer 1020 being covered by a layer 1030, e.g. a resist layer. By scanning the surface 1012 of the area of interest comprising the overlay mark (schematically indicated by the e-beam 1015, the interaction volume 1014 and the direction 1016), the buried structure, i.e. the overlay mark, can be identified and evaluated, in a similar manner as discussed above. In particular, the proper geometry of the first and second structures of the overlay mark may be assess, and the relative position of the structures, in the horizontal plane, thereby assessing the overlay error. As will be explained further on, the inspection tool according to the present invention may be equipped with multiple different sensors as well, e.g. sensors for detecting back scattering electrons or secondary electrons.

In an embodiment, the inspection tool according to the present invention is configured to assess the characteristic of a buried structure, either a material characteristic or a geometric characteristic, or assess a functionality, for a plurality of such structures, distributed across the semiconductor substrate. By doing so, any variations in said parameters may be detected at an early stage and may serve to adjust the various processes to which the substrates are subjected. In an embodiment of the present invention, the inspection tool according to the present invention is applied as an inline tool, arranged in a lithographic apparatus. In such embodiment, the substrate table that is used during the assessment of the stress distribution by the inspection tool, is also used during a subsequent exposure of the substrate to a patterned radiation beam. As such, in an embodiment, the present invention provides in a lithographic system comprising a lithographic apparatus and an inspection tool, whereby the lithographic apparatus comprises a stage apparatus configured to position the substrate table in an operating range of the e-beam, so as to scan the substrate with an e-beam of the e-beam source for inspection, and in an operating range of the projection system, so as to impart the substrate with the patterned radiation beam generated by the projection system. In such embodiment, the lithographic system may be configured to:
- inspect a substrate, while clamped on a substrate table that is positioned by the stage apparatus of the lithographic apparatus;
- determine a characteristic of a buried structure on an area of interest on the substrate;
- positioning the substrate, while on the substrate table, by the stage apparatus relative to a patterned radiation beam, whereby the process of positioning the substrate table or the process of generating the patterned radiation beam can be based on the determined characteristic.

In case the inspection tool is incorporated in the lithographic apparatus, it may e.g. be provided in a vacuum chamber of the apparatus, e.g. a dedicated vacuum chamber or a vacuum chamber that is already present, such as in an EUV lithographic apparatus.
In such an arrangement, care should also be taken to ensure the inspection tool, in particular the e-beam source, is not affected by magnetic fields that may be generated by the stage apparatus or other possible sources such as actuators. In order to realize this, an electromagnetic shielding may be applied.

As an alternative to incorporating the inspection tool in the lithographic apparatus, a lithographic system according to the present invention may comprise a lithographic apparatus, an inspection tool according to the invention and a transfer system for transferring a substrate from the inspection tool to the lithographic apparatus. In such embodiment, the transfer system may e.g. transfer the substrate while being clamped onto a substrate table, i.e. both substrate and substrate table are transferred together, in a clamped state, from the inspection tool to the lithographic apparatus.

As another alternative, the inspection tool according to the present invention may be a stand-alone tool having its own substrate table and an interface for transferring substrates to and from the tool.

In the above, it has been discussed that variations in the CL-light, in particular variations in the frequency spectrum of the captured CL-light may be used to identify different structures and materials and various characteristics of such materials or structures. In this respect, it is worth pointing out that other characteristics of the CL-light, apart from the frequency spectrum may be used as well to assess a state of the substrate or inspect the substrate. In addition to, or as an alternative to observing the frequency spectrum of the received CL-light, other characteristics of the received CL-light may be considered as well in order to assess transitions between structures or materials or to assess various characteristics of such materials or structures. Examples of such other characteristics may e.g. be a polarization characteristic of the CL-light, an orientation of the received CL-light or a transient characteristic of the CL-light. In a similar manner as the assessment of the frequency spectrum of the CL-light and its variation across an area of interest, so can an assessment of a polarization characteristic of the received CL-light be use to determine the occurrence of variations in material properties, including stress. Similarly, the orientation, in particular the angular orientation of the received CL-light may also be used to assess transitions between structures or materials or to characterize such structures or materials. Note that the angular orientation of the CL-light may e.g. be determined or characterized by the position at which the light impinges on the detector. With reference to Figure 2, it will be clear to the skilled person that the angular orientation of the CL-light, indicated by the arrows 140, affects the position at which the light impinges on the reflector 160 and thus also affect the position, at which the CL-light impinges the detector 150. Yet another characteristic of the CL-light is any transient, i.e. any variation over time, that may be perceived in the captured light.

The inspection tool according to the present invention is configured to detect CL-light emitted by an area of interest, e.g. a portion of a semiconductor substrate. An inspection of a substrate or a portion thereof based on the detection of CL-light may be performed faster than a detection based on back-scattering electrons. Typically, a comparatively large number of photons are generated during the exposure of a substrate with an e-beam, rendering the yield or throughput of this inspection method comparatively high, compared to e.g. the detection of back-scattering electrons. It may however be pointed out that a resolution of a detector detecting back-scattering electrons may be larger than a detector detecting CL-light.

In an embodiment of the present invention, the inspection tool may be provided with different types of detectors, e.g. including a back-scattering (BS) electron detector or a secondary electron (SE) detector. In such embodiment, the BS-detector or SE-detector may e.g. be used for calibration purposes. As an example, the BS-detector or SE-detector may e.g. be used to calibrate the CL-light detector.

In an embodiment of the present invention, the data obtained from the inspection tool may be combined with data obtained from other tools such as other inspection tools or metrology tools, whereby the combined set of data is used to determine a function characteristic or device functionality of the semiconductor device that is manufactured. As an example, the data of the inspection tool according to the present invention may e.g. be combined with data from a SEM (scanning electron microscope) or from OCD (Optical Critical Dimension) metrology, or may be combined with design parameters rather than other measurements. Using the data obtained from the inspection tool according to the present invention or the combined data, device functionalities such as device resistivity, layer thickness, dopant concentration, threshold voltage and others can be determined.

Using this information as feedback to a lithographic apparatus, e.g. to control the exposure process as performed, enables to improve both the device performances and the yield of the apparatus. The information as obtained may also be used in machine learning techniques to e.g. generate empirical models linking a CL-light characteristic as determined to a device characteristic such as an overlay characteristic.

In the above, the use of the inspection tool according to the present invention has been described for the purpose of inspecting a semiconductor substrate. It may however be pointed out that it may also be used for inspection of e.g. EUV blanks or EUV masks. An EUV blank, or quartz substrate that is used for manufacturing an EUV reticle or patterning device may contain defects. It can e.g. be pointed out that the yield of the manufacturing process for such EUV blanks that are sufficiently defect-free is comparatively low. An inspection of such an EUV blank prior to the application of e.g. a multilayer stack of Mo-Si may result in the detection of flawed blanks in an early stage. An inspection tool according to the present invention may enable such detection. In particular, the CL-light generated when the surface of an EUV blank is exposed to an e-beam is strongly influenced by the surface morphology. Due to this, a distinction between different types of defects may also be made. The defects of the quartz, e.g. on the surface, may create recombination centers where the emission of CL-light will be high. As such, the defect presence will be highlighted and the position may be determined. Crystalline defects may be detected as well, in a similar manner. As such, using an inspection tool according to the present invention, the surface of an EUV blank may be imaged, typically with a < 10 nm resolution, at a comparatively high speed. In addition, the inspection tool according to the present invention may also be applied to inspect a multilayered mask or reticle, e.g. masks provided with a stack of Mo and Si layers.

As such, in an embodiment of the present invention, there is provided an inspection tool for inspecting an EUV blank or an EUV mask, the inspection tool comprising
- an object table configured to hold the EUV blank or EUV mask;
- an electron beam source configured to project an electron beam onto an area of interest of the EUV blank or EUV mask;
- a cathode-luminesce detector configured to detect cathodoluminescent light emitted from the area of interest;
- a control unit configured to:
   - control the electron beam source to project to electron beam onto the area of interest;
   - receive a signal representative of the detected cathodoluminescent light;
   - determine, based on the signal, a characteristic or location of a defect on the area of interest.

Such a tool may be configured to perform the following inspection method:
An inspection method, the method comprising the steps of:
   - providing an EUV blank or an EUV mask with an area of interest;
   - scanning the area of interest using an electron beam;
   - capturing CL-light emitted from the area of interest;
   - determining a characteristic or location of a defect on the area of interest, based on the captured light.

The embodiments may further be described using the following clauses:
1. An inspection tool for inspecting a semiconductor substrate, the inspection tool comprising
   - an substrate table configured to hold the substrate;
   - an electron beam source configured to project an electron beam onto an area of interest of the substrate, the area of interest comprising a buried structure;
   - a cathode-luminesce detector configured to detect cathodoluminescent light emitted from the buried structure;
   - a control unit configured to:
      - receive a signal representative of the detected cathodoluminescent light;
      - determine, based on the signal, a characteristic of the buried structure.
2. The inspection tool according to clause 1, wherein the control unit is further configured to:
   - control the electron beam source to project the electron beam onto the area of interest;
3. The inspection tool according to clause 1 or 2, wherein the characteristic is a material characteristic of at least part of the buried structure.
4. The inspection tool according to clause 3, wherein the material characteristic is an electric characteristic or a chemical characteristic.
5. The inspection tool according to clause 3 or 4, wherein the control unit is configured to determine a frequency spectrum of the detected cathodoluminescent light.
6. The inspection tool according to clause 5, wherein the control unit is configured to determine the material characteristic based on the frequency spectrum.
7. The inspection tool according to clause 5 or 6, wherein the control unit is further configured to receive a signal representing a geometric characteristic of the structure and wherein the control unit is configured to assess the functionality of the semiconductor device, based on the material characteristic and the geometric characteristic.
8. The inspection tool according to clause 1 or 2, wherein the characteristic is a geometric characteristic of the structure.
9. The inspection tool according to clause 8, wherein the geometric characteristic comprises position information of the structure.
10. The inspection tool according to clause 9, wherein the position information comprises a position of the structure relative to a further structure.
11. The inspection tool according to clause 10, wherein the structure and the further structure are located in different layers of the semiconductor substrate.
12. The inspection tool according to clause 11, wherein the structure and the further structure form an overlay mark.
13. The inspection tool according to any of the clauses 8 to 12, wherein the signal represents an image of the buried structure and wherein the control unit is configured to determine the geometrical characteristic of the buried structure based on image processing of the image.
14. The inspection tool according to any of the preceding clauses, wherein the control unit comprises an output terminal for outputting a signal representative of the determined characteristic.
15. The inspection tool according to any of the preceding clauses, wherein the area of interest comprises a plurality of buried structures, distributed across the substrate and wherein the control unit is further configured to determine a variation of the characteristic for the plurality of buried structures.
16. The inspection tool according to clause 15, wherein the control unit is configured to output a signal representative of the variation of the characteristic.
17. The inspection tool according to any of the preceding clauses, wherein the electron beam source is configured to project a plurality of electron beams onto a respective plurality of sub-areas of the area of interest.
18. The inspection tool according to any of the preceding clauses, wherein the electron beam source is configured to generate electron beams having a different energy level.
19. The inspection tool according to clause 18, wherein the control unit is configured to:
   - control the electron beam source to project a plurality of electron beams with different energy levels onto the area of interest;
   - receive a respective plurality of signals representative of the detected cathodoluminescent light;
   - determine, based on the plurality of signals, the characteristic of the buried structure.
20. The inspection tool according to any of the preceding clauses, further comprising a back-scattering (BS) electron detector configured to detect back-scattering electrons emitted from the area of interest.
21. The inspection tool according to clause 20, wherein the control unit is configured to:
   - receive a signal representative of the detected back-scattering electrons, and
   - determine the characteristic based on the signal representative of the detected cathodoluminescent light and the signal representative of the detected back-scattering electrons.
22. The inspection tool according to any of the preceding clauses, wherein the control unit is configured to:
   - determine an angular orientation, a polarization or a transient of the detected cathodoluminescent light.
23. The inspection tool according to clause 22, wherein the control unit is configured to:
   - determine the characteristic of the buried structure based on the angular orientation, the polarization or the transient of the detected cathodoluminescent light.
24. A lithographic apparatus comprising:
   - an illumination system configured to condition a radiation beam;
   - a support constructed to support a patterning device, the patterning device being capable of imparting the radiation beam with a pattern in its cross-section to form a patterned radiation beam;
   - a projection system configured to project the patterned radiation beam onto a target portion of a substrate;
   wherein the apparatus further comprises an inspection tool according to any of the preceding clauses and a stage apparatus configured to position the substrate table so as to impart the substrate with the patterned radiation beam.
25. The lithographic apparatus according to clause 24, further comprising a stage control unit configured to control the stage apparatus, the stage control unit configured to receive a signal representative of the characteristic of the buried structure and wherein the stage control unit is configured to control the stage apparatus based on the characteristic.
26. The lithographic apparatus according to clause 24 or 25, further comprising a projection control unit configured to control the projection system and illumination system, the projection control unit configured to receive a signal representative of the characteristic of the buried structure and wherein the projection control unit is configured to control the projection system and/or the illumination system based on the characteristic.
27. The lithographic apparatus according to any of the clauses 24 to 26, wherein the substrate table comprises a clamping mechanism for clamping the substrate to the substrate table.
28. The lithographic apparatus according to any of the clauses 24 to 27, further comprising a vacuum chamber configured to enclose the electron beam source.
29. The lithographic apparatus according to clause 28, wherein the vacuum chamber further encloses the projection system.
30. The lithographic apparatus according to any of the clauses 24 to 29, wherein the stage apparatus comprises one or more electromagnetic motors and wherein the lithographic apparatus further comprises a shielding member configured to shield the electron beam source from a magnetic field of the stage apparatus.
31. A lithographic system comprising:
   - an inspection tool according to any of the clauses 1 to 23 and
   - a lithographic apparatus comprising:
      - an illumination system configured to condition a radiation beam;
   - a support constructed to support a patterning device, the patterning device being capable of imparting the radiation beam with a pattern in its cross-section to form a patterned radiation beam;
   - a projection system configured to project the patterned radiation beam onto a target portion of a substrate;
   - a stage apparatus configured to position the substrate table so as to impart the substrate with the patterned radiation beam.
32. An inspection method, the method comprising the steps of:
   - providing a substrate with an area of interest, the area of interest comprising a buried structure;
   - scanning the area of interest using an electron beam;
   - capturing CL-light emitted from the area of interest;
   - determining a characteristic of the buried structure.
33. The inspection method according to clause 32, further comprising:
   - generating an image of the buried structure based on the captured CL-light; and
   - determining the characteristic of the buried structure based on the generated image.
34. The inspection method according to clause 32 or 33, wherein the buried structure comprises a stack comprising a first layer and a second layer, the geometric property being a relative position between a first portion of the buried structure in the first layer and a second portion of the buried structure in the second layer.
35. A device manufacturing method comprising projecting a patterned beam of radiation onto a substrate, wherein the step of projecting the patterned beam of radiation onto the substrate is preceded by the inspection method according to any of the clauses 32 to 34.

Although specific reference may be made in this text to the use of lithographic apparatus in the manufacture of ICs, it should be understood that the lithographic apparatus described herein may have other applications, such as the manufacture of integrated optical systems, guidance and detection patterns for magnetic domain memories, flat-panel displays, liquid-crystal displays (LCDs), thin-film magnetic heads, etc. The skilled artisan will appreciate that, in the context of such alternative applications, any use of the terms "wafer" or "die" herein may be considered as synonymous with the more general terms "substrate" or "target portion", respectively. The substrate referred to herein may be processed, before or after exposure, in for example a track (a tool that typically applies a layer of resist to a substrate and develops the exposed resist), a metrology tool and/or an inspection tool. Where applicable, the disclosure herein may be applied to such and other substrate processing tools. Further, the substrate may be processed more than once, for example in order to create a multi-layer IC, so that the term substrate used herein may also refer to a substrate that already contains multiple processed layers.

Although specific reference may have been made above to the use of embodiments of the invention in the context of optical lithography, it will be appreciated that the invention may be used in other applications, for example imprint lithography, and where the context allows, is not limited to optical lithography. In imprint lithography a topography in a patterning device defines the pattern created on a substrate. The topography of the patterning device may be pressed into a layer of resist supplied to the substrate whereupon the resist is cured by applying electromagnetic radiation, heat, pressure or a combination thereof. The patterning device is moved out of the resist leaving a pattern in it after the resist is cured.

The terms "radiation" and "beam" used herein encompass all types of electromagnetic radiation, including ultraviolet (UV) radiation (e.g. having a wavelength of or about 365, 248, 193, 157 or 126 nm) and extreme ultra-violet (EUV) radiation (e.g. having a wavelength in the range of 5-20 nm), as well as particle beams, such as ion beams or electron beams.

The term "lens", where the context allows, may refer to any one or combination of various types of optical components, including refractive, reflective, magnetic, electromagnetic and electrostatic optical components.

While specific embodiments of the invention have been described above, it will be appreciated that the invention may be practiced otherwise than as described. For example, the invention may take the form of a computer program containing one or more sequences of machine-readable instructions describing a method as disclosed above, or a data storage medium (e.g. semiconductor memory, magnetic or optical disk) having such a computer program stored therein.

The descriptions above are intended to be illustrative, not limiting. Thus, it will be apparent to one skilled in the art that modifications may be made to the invention as described without departing from the scope of the claims set out below.

## Claims

1. An inspection tool for inspecting a semiconductor substrate, the inspection tool comprising
- an substrate table configured to hold the substrate;
- an electron beam source configured to project an electron beam onto an area of interest of the substrate, the area of interest comprising a buried structure;
- a cathode-luminesce detector configured to detect cathodoluminescent light emitted from the buried structure;
- a control unit configured to:
- receive a signal representative of the detected cathodoluminescent light;
- determine, based on the signal, a characteristic of the buried structure.

2. The inspection tool according to claim 1, wherein the control unit is further configured to:
- control the electron beam source to project the electron beam onto the area of interest;

3. The inspection tool according to claim 1 or 2, wherein the characteristic is a material characteristic of at least part of the buried structure.

4. The inspection tool according to claim 3, wherein the material characteristic is an electric characteristic or a chemical characteristic.

5. The inspection tool according to claim 3 or 4, wherein the control unit is configured to determine a frequency spectrum of the detected cathodoluminescent light.

6. The inspection tool according to claim 5, wherein the control unit is configured to determine the material characteristic based on the frequency spectrum.

7. The inspection tool according to claim 5 or 6, wherein the control unit is further configured to receive a signal representing a geometric characteristic of the structure and wherein the control unit is configured to assess the functionality of the semiconductor device, based on the material characteristic and the geometric characteristic.

8. The inspection tool according to claim 1 or 2, wherein the characteristic is a geometric characteristic of the structure.

9. The inspection tool according to claim 8, wherein the geometric characteristic comprises position information of the structure.

10. The inspection tool according to claim 9, wherein the position information comprises a position of the structure relative to a further structure.

11. The inspection tool according to claim 10, wherein the structure and the further structure are located in different layers of the semiconductor substrate.

12. The inspection tool according to any of the claims 8 to 11, wherein the signal represents an image of the buried structure and wherein the control unit is configured to determine the geometrical characteristic of the buried structure based on image processing of the image.

13. The inspection tool according to any of the preceding claims, wherein the electron beam source is configured to generate electron beams having a different energy level, and wherein the control unit is configured to:
- control the electron beam source to project a plurality of electron beams with different energy levels onto the area of interest;
- receive a respective plurality of signals representative of the detected cathodoluminescent light;
- determine, based on the plurality of signals, the characteristic of the buried structure.

14. The inspection tool according to any of the preceding claims, further comprising a back-scattering (BS) electron detector configured to detect back-scattering electrons emitted from the area of interest, and wherein the control unit is configured to:
- receive a signal representative of the detected back-scattering electrons, and
- determine the characteristic based on the signal representative of the detected cathodoluminescent light and the signal representative of the detected back-scattering electrons.

15. The inspection tool according to any of the preceding claims, wherein the control unit is configured to:
- determine an angular orientation, a polarization or a transient of the detected cathodoluminescent light, and
- determine the characteristic of the buried structure based on the angular orientation, the polarization or the transient of the detected cathodoluminescent light.
